Europäisches Patentamt

European Patent Office

Office européen des brevets

(19)

(11) Numéro de publication : **0 670 574 A1**

(12)

# DEMANDE DE BREVET EUROPEEN

(21) Numéro de dépôt : 95400245.7

(51) Int. Cl.$^6$ : **G11C 19/08,** G01D 5/14

(22) Date de dépôt : **06.02.95**

(30) Priorité : **09.02.94 FR 9401456**

(43) Date de publication de la demande :
**06.09.95 Bulletin 95/36**

(84) Etats contractants désignés :
**CH DE FR GB LI**

(71) Demandeur : **SOCIETE D'APPLICATIONS
GENERALES D'ELECTRICITE ET DE
MECANIQUE SAGEM
6, Avenue d'Iéna
F-75783 Paris Cédex 16 (FR)**

(72) Inventeur : **Zimmermann, Laurent
394 Rue du Bout de la Ville
F-76380 Montigny (FR)**
Inventeur : **Pougnet, Philippe
14 Rue de l'Harmonie
F-95490 Vaureal (FR)**

(74) Mandataire : **Fort, Jacques
CABINET PLASSERAUD
84, rue d'Amsterdam
F-75440 Paris Cedex 09 (FR)**

(54) Dispositif à micro-circuit à bulles magnétiques et moyens de lecture.

(57)     Le dispositif est utilisable pour compter le
nombre de tours d'un aimant rotatif (26). Il a au
moins une boucle comportant plusieurs motifs
de circulation de bulles magnétiques, placées
par rapport à l'aimant de façon que chaque tour
du champ tournant fasse passer les bulles d'un
motif de chaque boucle au motif suivant, des
moyens de création d'un champ de polarisation
(Hb) orthogonal au micro-circuit et des moyens
de lecture de la présence d'une bulle magnétique sur un motif particulier de la boucle ou de
chaque boucle. Les moyens de lecture
comprennent des moyens de détection de l'orientation du champ tournant, et des moyens de
création d'un champ magnétique alternatif (Ha)
à fréquence supérieure à la fréquence angulaire
maximale du champ tournant de l'aimant lorsque ledit champ tournant est dans une orientation déterminée, et des moyens de détection de
l'oscillation de la bulle éventuellement présente
sur au moins un motif par variation d'un signal
de sortie à la fréquence du champ alternatif.

FIG.3.

EP 0 670 574 A1

La présente invention concerne les dispositifs à micro-circuit à bulles magnétiques, et elle trouve une application particulièrement importante dans les dispositifs de comptage du nombre de tours effectués par un aimant rotatif.

Les dispositifs à micro-circuit à bulles magnétiques comportent classiquement au moins une boucle à motifs de circulation des bulles, des moyens de génération de bulles dans un motif de la boucle, des moyens de création d'un champ de polarisation orthogonal au micro-circuit et des moyens de création d'un champ tournant d'entraînement des bulles le long de la boucle, ainsi que des moyens de lecture destinés à détecter la présence d'une bulle sur au moins un motif particulier.

Dans un tel dispositif, chaque fois que l'on cherche à déterminer la position d'une bulle (ou de bulles) le long de la boucle, il est nécessaire de faire avancer la bulle (ou les bulles) jusqu'à ce qu'elles se trouvent sous les moyens de lecture et de compter le nombre de motifs parcourus jusqu'au motif de lecture. Cela est à l'heure actuelle obtenu en utilisant un champ tournant. Dans le cas des dispositifs de comptage du nombre de tours effectués par un aimant de génération d'un champ tournant, la lecture exige alors des moyens de génération d'un champ tournant de lecture, de phase et d'amplitude bien contrôlées, ayant une fréquence angulaire très supérieure à la fréquence maximale de rotation du champ tournant de l'aimant.

L'utilisation d'un tel champ tournant de lecture supplémentaire a des inconvénients. Il est difficile de maintenir une amplitude constante du champ tournant total qui est la somme du champ de lecture et du champ de l'aimant. Or, un défaut de compensation du champ de l'aimant peut perturber la propagation de la bulle ou des bulles. Dans le cas d'un dispositif compteur des tours d'un aimant, il est en général nécessaire d'effectuer plusieurs tours de champ tournant de lecture dans un sens pour la lecture, puis dans l'autre sens pour ramener les bulles à leur place, faute de quoi la lecture serait destructive. Enfin, il est nécessaire de détecter au moins approximativement la position angulaire du champ de l'aimant permanent, cette dernière contrainte ayant cependant été très allégée par mise en oeuvre des moyens décrits dans la demande de brevet FR 92 01099 de la demanderesse, à laquelle on pourra se reporter.

La présente invention vise notamment à fournir un dispositif à micro-circuit à bulles magnétiques répondant mieux que ceux antérieurement connus aux exigences de la pratique, notamment en ce qu'il écarte ou du moins réduit notablement les inconvénients ci-dessus mentionnés.

Dans ce but, l'invention propose notamment un dispositif à micro-circuit conforme à la revendication 1.

Un tel dispositif permet une lecture sans faire passer une bulle d'un motif à un autre.

L'invention propose également un dispositif à micro-circuit de comptage du nombre de tours d'un aimant rotatif, conforme à la revendication 2.

Dans la pratique, le rapport entre la fréquence du champ magnétique alternatif et la fréquence angulaire maximale du champ tournant de l'aimant dépassera toujours 50 et il sera en général supérieur à 100.

Un tel dispositif permet de détecter la présence de bulles placées sur les motifs de chaque boucle sans que la position des bulles ait été modifiée à l'issue de la mesure, ce qui supprime la nécessité d'avoir à ramener les bulles à leur place d'origine par un nombre de tours de champ tournant égal au nombre de tours pour la lecture. Le champ magnétique alternatif peut être de direction constante lorsqu'il est acceptable de ne déplacer les bulles que d'une quantité faible. Cette solution a l'avantage qu'il est beaucoup plus facile de créer, avec une ou des bobines, un champ alternatif (qui n'est pas obligatoirement sinusoïdal) qu'un champ tournant par composition de deux champs alternatifs sinusoïdaux. Cependant on sera souvent amenés, pour des raisons de fiabilité, à utiliser un champ tournant alternatif. D'autres caractéristiques secondaires encore sont exposées dans les sous-revendications.

L'invention sera mieux comprise à la lecture de la description qui suit d'un mode particulier de réalisation de l'invention, donné à titre d'exemple non limitatif. La description se réfère aux dessins qui l'accompagnent, dans lesquels :

- la fig. 1 est un schéma de principe d'une boucle de comptage ;
- la fig. 2 est un diagramme montrant la variation du signal de sortie d'un détecteur magnéto-résistif en fonction de l'angle θ de la fig. 1 ;
- la fig. 3 est un schéma de principe montrant en perspective une constitution possible de la partie magnétique d'un dispositif de comptage de tours et montrant une électronique annexe ;
- la fig. 4 est un schéma montrant une disposition relative possible d'une boucle et des détecteurs associés ;
- la fig. 5 montre un mode de sélection du zéro d'un dispositif de comptage de tours ;
- la fig. 6 est un schéma synoptique montrant comment adapter le dispositif à la mesure du nombre de tours d'un champ tournant dans un sens ou dans l'autre ;
- la fig. 7 est un diagramme destiné à faire apparaître la plage temporelle de mesure possible d'un dispositif ;
- la fig. 8, similaire à la fig. 3, montre une variante de réalisation ; et
- la fig. 9 est un diagramme explicatif du fonctionnement du dispositif de la fig. 8 ;
- la fig. 10, similaire à la fig. 2, montre une courbe de variation relevée expérimentalement ;

- la fig. 11 est un diagramme destiné à illustrer les plages de fonctionnement utilisées dans une variante de réalisation ; et
- la fig. 12, similaire à une fraction de la fig. 3, montre une variante.

Avant de décrire un dispositif compte-tours complet, le principe mis en oeuvre par l'invention sera indiqué en faisant référence à une seule boucle de comptage d'un micro-circuit.

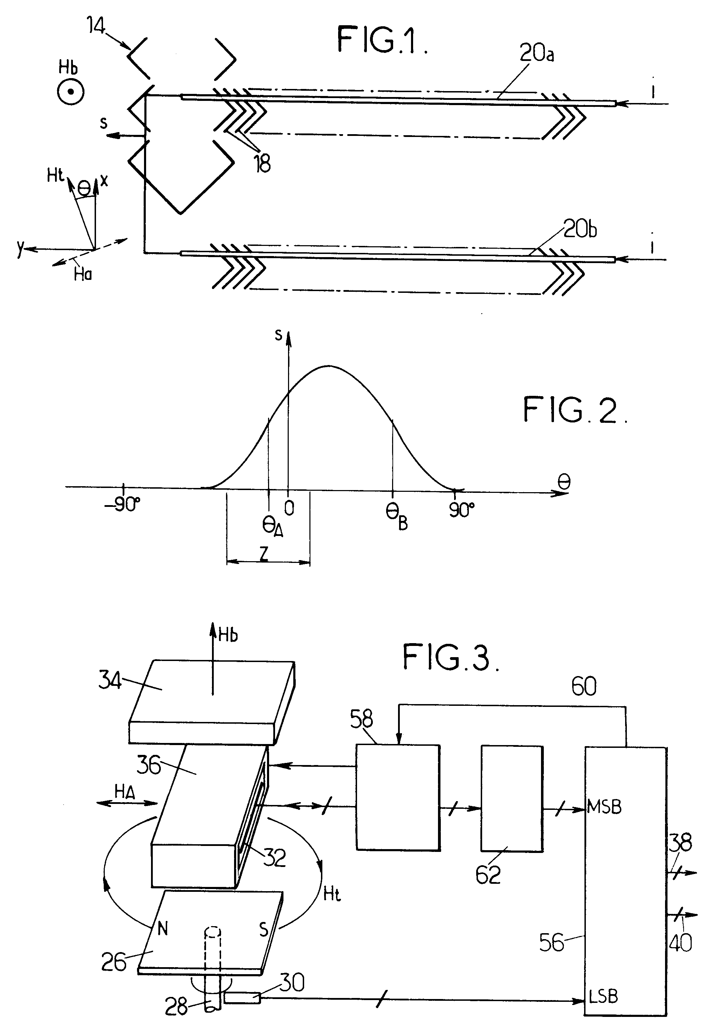

La fig. 1 montre une fraction d'une telle boucle, constituée de motifs successifs en forme de chevron, en fer-nickel épais, dont seuls quelques-uns sont représentés. La boucle comporte une zone d'extension de bulle 18, schématisée par une série de motifs alignés sous un barreau 20a en fer-nickel mince, qui constitue un détecteur actif. Il est identique à un détecteur passif 20b, placé à proximité, au-dessus de motifs alignés mais non soumis à l'action de bulles magnétiques. Les deux détecteurs sont montés en différentiel, dans des moyens de lecture comportant des moyens permettant d'alimenter les deux barreaux en un même courant constant i et des moyens de détection du signal différentiel résultant. De tels moyens détecteurs, utilisant le fait que la résistance des barreaux varie selon que l'aimantation est parallèle ou perpendiculaire au courant i, sont bien connus. Le rôle de la zone d'extension est d'allonger la bulle magnétique sur toute la longueur du barreau détecteur 20a lorsque la bulle est dans la zone d'extension et ainsi d'augmenter la sensibilité.

Sur la fig. 1 ont également été représentés le champ constant de polarisation Hb, orienté perpendiculairement au plan de la boucle et nécessaire à la stabilisation des bulles, ainsi que le champ tournant Ht d'un aimant dont le nombre de tours est à mesurer. L'angle du champ tournant Ht avec un axe Ox arbitraire, appartenant à un système d'axe Oxy situé dans le plan de la boucle, est désigné par $\theta$.

Le signal différentiel s fourni par le détecteur dépend fortement de l'angle $\theta$ lorsqu'une bulle se trouve dans la zone d'extension, puisque la bulle se déplace le long du motif lorsque $\theta$ change.

Dans certains cas, l'allure de la courbe de variation est celle donnée sur la fig. 2 lorsque les motifs sont en forme de chevrons et que $\theta = 0$ correspond à un champ Ht orthogonal au détecteur actif 20a. Le signal s prend une valeur à peu près égale à 50 % du maximum pour des angles $\theta_A$ et $\theta_B$, respectivement proches de - 15° et de + 45°.

L'invention utilise cette propriété. Pour cela, suivant l'invention, on superpose, au champ tournant Ht de l'aimant dont le nombre de tours est à mesurer, un champ alternatif Ha dans le plan de la boucle.

Dans un premier mode de réalisation, montré en figure 3, le déplacement du champ Ha est linéaire, dans une direction sensiblement perpendiculaire à Ht, à fréquence angulaire beaucoup plus élevée que celle du champ Ht. Lorsque Ht fait avec Ox l'angle $\theta_A$

ou $\theta_B$ (c'est-à-dire correspond à un signal s égal à la moitié du signal maximum), le champ Ha fait "vibrer" chaque bulle autour de sa position d'équilibre sur le motif (ou les motifs de la zone d'extension) qu'elle occupe. Cela revient à déplacer le point représentatif du signal sur la courbe de la fig. 2, de part et d'autre du point correspondant à l'angle $\theta_A$ ou $\theta_B$.

L'amplitude du champ alternatif Ha, indiqué sur la fig. 1 par une ligne en tirets, est telle que le point de fonctionnement ne dépasse pas le maximum et le minimum du signal. Il est possible et avantageux, de dépasser la partie quasi linéaire de la caractéristique de la fig. 2.

L'expérience montre que la fréquence d'excitation, destinée à créer le champ Ha, peut dépasser 100 KHz sans difficulté. La tolérance sur le positionnement lors de la mesure du champ Ht (qu'on peut qualifier de statique du fait qu'il varie beaucoup plus lentement que le champ alternatif) est de l'ordre de 10°. Une excursion de ± 30° de part et d'autre du point de polarisation statique, c'est-à-dire un fonctionnement dans la zone Z de la fig. 2, a donné de bons résultats : elle correspond sensiblement à une amplitude de Ha à peu près moitié de Ht.

La "vibration" des bulles provoque une modulation du signal s, à la fréquence d'excitation, qui est en phase ou en opposition de phase avec l'excitation, suivant que l'oscillation s'effectue autour de l'angle $\theta_A$ ou $\theta_B$.

La disposition relative des différents composants du dispositif peut être celle indiquée schématiquement en fig. 3, dans le cas d'un dispositif destiné à compter le nombre de tours effectués par un aimant 26 porté par un arbre 28 muni d'un codeur angulaire 30 fournissant la valeur de l'angle $\theta$ de 0 à $2\pi$. Dans le mode de réalisation illustré, le codeur 30 est de type numérique et fournit l'angle $\theta$ en permanence sous forme d'un mot ayant six éléments binaires ou "bits" au minimum, afin d'avoir la résolution nécessaire. L'élément actif du micro-circuit à bulles est constitué par une puce 32 qu'un aimant de polarisation 34 (ou un couple de deux aimants) soumet au champ magnétique permanent Hb orthogonal au plan de la puce.

Ce codeur angulaire peut être remplacé par une boussole électronique sensible au champ magnétique tournant, du genre décrit dans la demande de brevet FR 92 01099 à laquelle on pourra se reporter.

La puce peut avoir une constitution couramment utilisée pour la fabrication de mémoires à bulles magnétiques. Elle est alors formée sur un substrat non magnétique revêtu d'une pellicule épitaxiée de grenat ferri-magnétique, recouverte elle-même d'une couche d'espacement isolante, d'un espaceur en polyimide sous lequel sont enterrées des pistes de liaison électrique, portant les motifs de propagation 14 en fernickel épais.

Le dispositif, suivant l'invention, comporte également une bobine d'excitation 36 entourant la puce et fournissant le champ Ha destiné à faire "vibrer" les bulles et des moyens électroniques associés à la puce 32 et à la bobine 36. Ces moyens servent à détecter l'emplacement des bulles dans la puce, à décoder l'information ainsi obtenue, à calculer le nombre de tours, et à fournir, sur un accès de sortie 38, le nombre de tours N effectués par l'arbre 28. L'électronique peut également être prévue pour donner la position angulaire θ de l'angle 28 sur une sortie 40 : les sorties 38 et 40 fournissent ainsi les chiffres de poids forts et faibles identifiant la rotation de l'aimant.

Pour que toute l'information nécessaire à la mesure du nombre de tours effectués puisse être obtenue, quel que soit ce nombre jusqu'à un maximum, et cela par simple "vibration", en une seule opération de mesure, chaque boucle contiendra en général, non pas une bulle unique, mais une séquence de 0 et de 1 formés de bulles réparties pour constituer un cycle de Bruijn dont on trouvera des exemples dans la demande de brevet français n° 92 01099. Avec de telles séquences, il suffit de lire quelques bits consécutifs dans des motifs consécutifs de chaque boucle pour pouvoir déterminer le nombre de tours, à l'aide d'une table de correspondance stockée dans une mémoire non volatile appartenant à l'électronique.

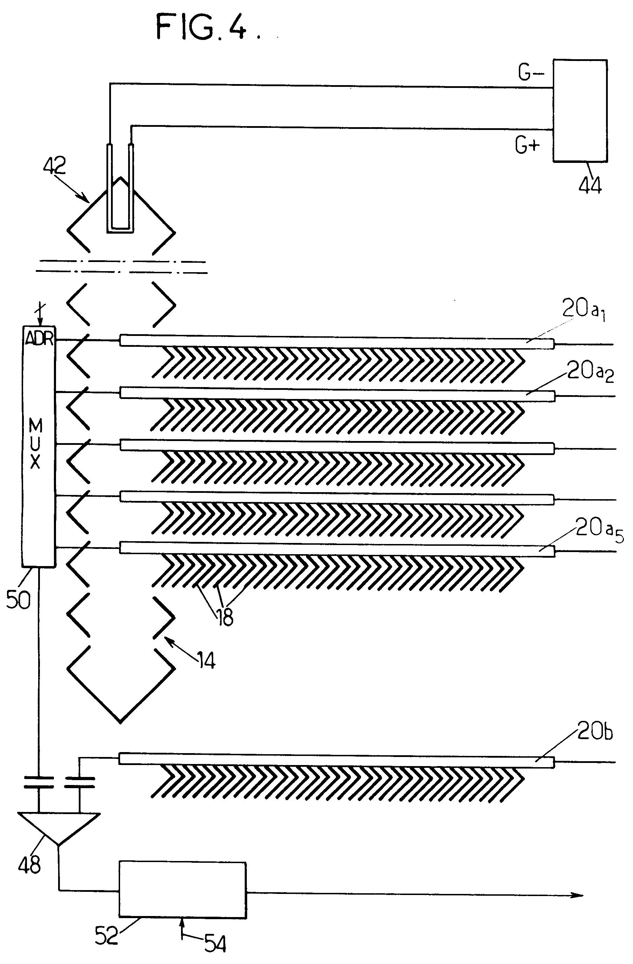

Plutôt que d'utiliser un seul détecteur actif, comme illustré sur la fig. 1, on adoptera des moyens de lecture ayant plusieurs détecteurs magnéto-résistifs actifs, permettant de lire simultanément tous les bits consécutifs nécessaires pour déterminer le nombre de tours, grâce à l'utilisation d'une séquence de 0 et de 1 générée à partir de cycles de Bruijn. La fig. 4 (où les éléments correspondant à ceux déjà montrés en fig. 1 portent le même numéro de référence) donne la constitution schématique d'une boucle de comptage à cinq détecteurs actifs. La boucle comporte un générateur de bulles 42 permettant de créer des bulles suivant les séquences nécessaires, à partir d'une source 44 d'initialisation. Les cinq barreaux de fer-nickel mince $20a_1$ -$20a_5$ peuvent être associés à un ou des barreaux 20b constituant en détecteur passif, par l'intermédiaire de pistes conductrices, généralement formées par un dépôt mince d'or.

Pour simplifier l'électronique, chaque boucle peut comporter un seul amplificateur différentiel 48 dont l'une des entrées est attaquée par les détecteurs actifs par l'intermédiaire d'un multiplexeur 50 (fig. 4).

Un condensateur de couplage capacitif, arrêtant la composante continue, est interposée sur la sortie analogique du multiplexeur et celle du détecteur passif. L'amplificateur est muni d'un filtre passe-bande isolant la fréquence de modulation du champ alternatif Ha où il est prévu pour effectuer une démodulation synchrone. Le comparateur 52 reçoit un seuil fixe de détection de bulle sur une entrée 54.

Pour que la capacité de comptage soit supérieure au nombre de motifs dans une boucle, le micro-circuit comportera en général plusieurs boucles, parcourues chacune par des bulles réparties pour constituer des séquences de 0 et de 1, les boucles ayant des nombres de motifs qui sont premiers entre eux deux à deux.

On peut notamment constituer un micro-circuit ayant 23 plots de sortie, avec trois boucles ayant respectivement 27, 29 et 32 motifs, à condition que les trois générateurs 44 et les 6 x 3 = 18 détecteurs aient des connexions communes formées par les sorties s et, par exemple, G+. Deux registres suffisent dans beaucoup de cas.

L'électronique du dispositif peut avoir la constitution de principe indiquée en fig. 3. Elle comporte un interface 56, entre le codeur angulaire 30 et l'électronique de détection des bulles 58. L'interface comportera généralement un décodeur d'angle de lecture qui adresse à l'électronique 58 de détection des bulles une impulsion de déclenchement, sur une liaison 60, chaque fois que l'aimant 26 prend l'orientation déterminée $θ_A$ (ou $θ_B$, selon un choix arbitraire) L'électronique de détection 58 est prévue pour générer le champ alternatif Ha et pour détecter la présence de bulles sur cinq motifs successifs à la fois. L'électronique 58 attaque des circuits de décodage et de calcul 62 fournissant le nombre de tours. On peut considérer que l'ensemble des sorties 38 et 40 fournit une information comportant le nombre de tours effectués, sur la sortie 38, et l'angle supplémentaire, sur la sortie 40 : six bits donnent une résolution de 6° environ. Le circuit de décodage 62 comporte une table de correspondance, en mémoire morte, permettant de convertir le mot de cinq bits fournis successivement par le détecteur à seuil 52, en un mot de cinq bits correspondant au nombre de tours effectués.

La séquence de lecture peut être la suivante : la lecture intervient chaque fois que l'angle θ prend la valeur choisie, $θ_A$ ou $θ_B$. Le codeur angulaire 30 peut être orienté de façon que l'orientation de lecture corresponde à une valeur π indiquée par ce détecteur 30, et cette hypothèse sera utilisée par la suite.

Dès réception de l'impulsion de lecture fournie par l'interface 56, la bobine d'excitation 36 est alimentée pour fournir un champ alternatif, à une fréquence au moins cinquante fois supérieure à la fréquence angulaire maximum de rotation de l'aimant. Dans le cas d'une vitesse maximale de 12.000 tours par minute, on peut notamment utiliser une fréquence comprise entre 10 KHz et 1 MHz. Cette fréquence est facilement atteinte en alimentant la bobine 36 par un signal carré. Les dix-huit détecteurs sont alimentés par un courant i et le signal du détecteur est amplifié et comparé au seuil. Si un champ tournant de 60 Oe est utilisé pour la propagation des bulles, un champ alternatif Ha oscillant entre + 30 Oe et - 30 Oe est suffisant pour l'excitation.

Si on suppose que trois boucles sont utilisées, ayant respectivement 27, 29 et 32 motifs, le nombre de tours peut être mesuré jusqu'à $N_2=25.056$ tours, par un algorithme bien connu et implémentable en logiciel à l'aide d'un micro-contrôleur incorporé dans l'interface 56.

Souvent, il est souhaitable que l'utilisateur du dispositif puisse définir un point de départ du comptage sans avoir à réécrire les bulles dans la boucle. Pour cela, il est nécessaire que l'interface 56 ne délivre pas le nombre N de tours faits depuis l'initialisation, mais un nombre Nu :

$$Nu = e (N_2 - N_0) + a. 25.056$$

ou :

$e = \pm 1$ correspond au sens de comptage ;

$N_0$ est le nombre de tours défini comme origine, $N_0$ étant compris entre 0 et 25.056 et pouvant par exemple être 25.056/2 ;

a est égal à 1, 0 ou - 1 et permet de corriger la discontinuité du compteur à bulles lorsque, par suite d'un fonctionnement en sens inverse, on arrive au-dessous de zéro.

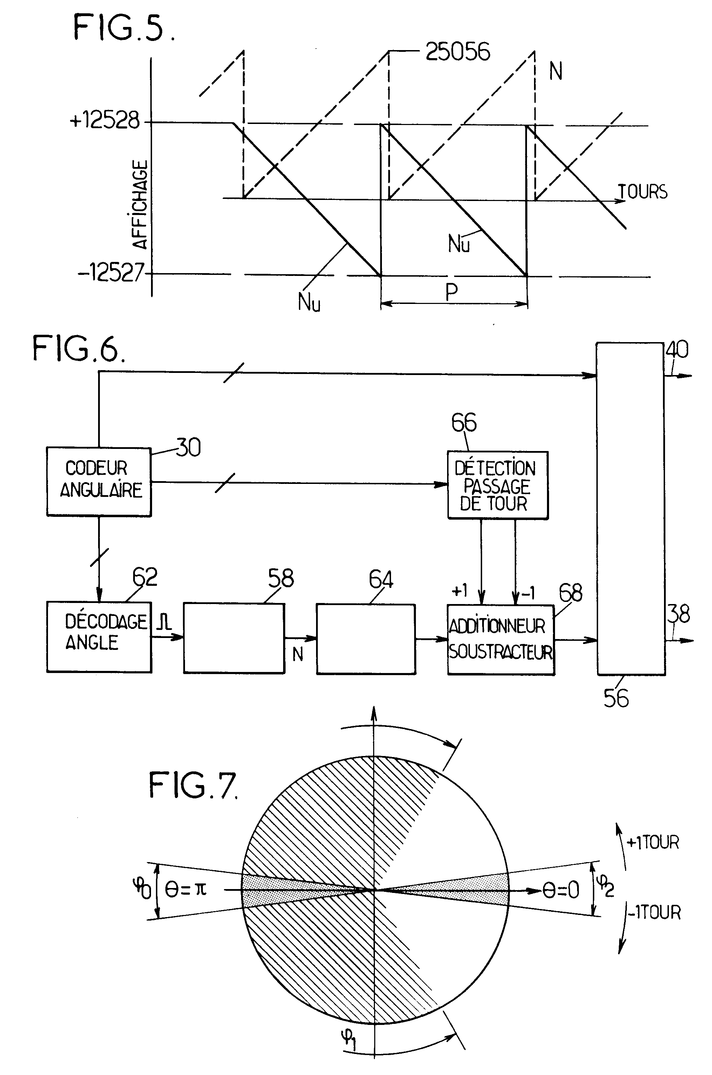

Ce mode de sélection du 0 est schématisé sur la fig. 5, pour le cas où l'on souhaite mesurer le nombre de tours effectués, dans un sens ou dans l'autre, jusqu'à un maximum égal à 25.056/2 (plage P).

Le codeur angulaire 30 peut également être utilisé pour indiquer le passage de l'aimant dont le nombre de tours est à mesurer par une orientation opposée à celle où a lieu la mesure. Si, par exemple, l'orientation de mesure correspond à un angle $\pi$ du codeur, ce dernier permet de déterminer le passage à 0, c'est-à-dire l'augmentation ou la diminution d'un tour. Ainsi, il est possible de connaître en permanence le nombre de tours effectués, en dépit du fait que la mesure absolue n'est possible que pour l'orientation $\pi$, même si les deux sens de rotation sont possibles.

La fig. 6 montre un montage permettant de fournir l'information supplémentaire requise. Le décodeur 62 (qui peut être intégré à l'interface 56) fournit à l'électronique 58 une impulsion de déclenchement pour l'angle $\pi$. Le bloc 64 (qui peut être constitué par un programme du micro-contrôleur) effectue la correction qui permet de passer de N modulo 25.056 à Nu.

Un détecteur de changement de tour 66 exploite la variation du signal de sortie du codeur 30 autour de l'angle 0 et fournit un signal + 1 d'incrémentation ou - 1 de décrémentation, suivant le cas, à un additionneur-soustracteur 68 qui passe à Nu + 1 ou Nu - 1, suivant le cas. La sélection du signal peut notamment être faite en déterminant le sens d'évolution des deux bits les plus significatifs de sortie du codeur angulaire 30. L'additionneur-soustracteur 68 peut comporter un registre dans lequel est chargé Nu après chaque lecture du compteur à bulles et qui est mis à jour lors des passages de $\theta$ par 0.

Nu doit être disponible avant que $\theta$ ne soit passé par 0. Le laps de temps autorisé pour effectuer la détection des bulles, le décodage et le calcul de N, et la correction par l'utilisateur doit donc être inférieur à une demi-période de rotation de l'aimant à sa vitesse maximale, soit 5 ms pour une vitesse de 6000 t/mn.

Si cette condition est remplie, la continuité de l'information délivrée en sortie est assurée, c'est-à-dire que lorsque le codeur angulaire passe de 111111 à 000000 le nombre de tours Nu passe automatiquement de N à N + 1. La précision du système sur la rotation de l'aimant est celle du codeur angulaire.

La fig. 7 montre, de façon plus générale, que la zone d'orientation de Ht pour laquelle une mesure absolue est possible est limitée. Le début de lecture doit intervenir dans un angle $\varphi$, de part et d'autre d'une orientation $\theta_A$ (égale à $\pi$ dans le cas illustré). La lecture absolue doit se terminer avant que l'orientation du champ ne soit sortie de $\varphi_1$. Enfin, le passage d'un tour à l'autre est détecté pendant que l'orientation est dans la plage $\varphi_2$.

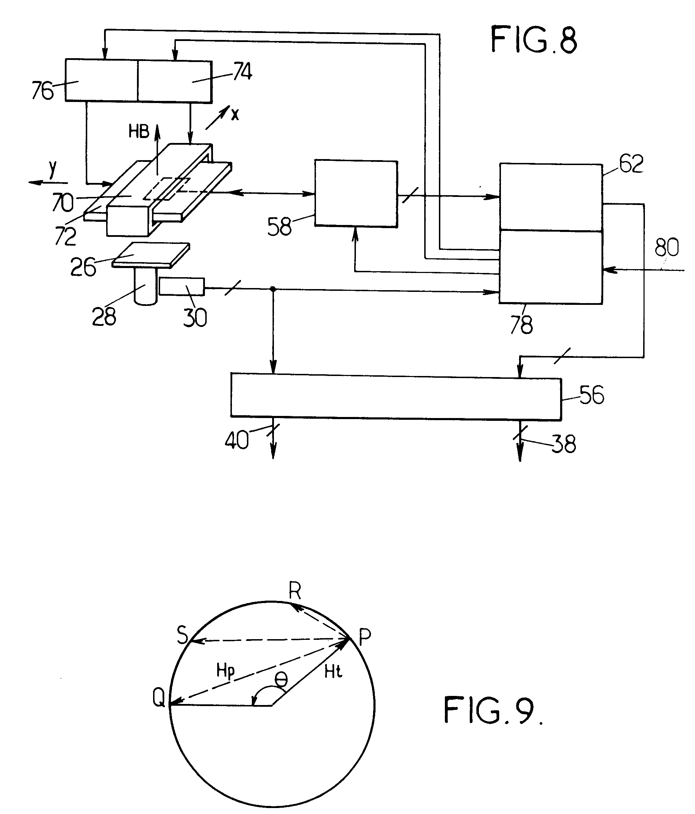

On décrira maintenant, en faisant référence aux figures 8 et 9, un autre mode de réalisation qui permet, au prix de l'adjonction de quelques composants, d'écarter une limitation des réalisations précédemment mentionnées.

Le dispositif montré en figure 8, où les éléments similaires à ceux déjà mentionnés sont désignés par le même numéro de référence, comportent de plus des moyens destinés à créer un champ Hp dans le plan du microcircuit, résultant de la composition de deux champs orthogonaux, dirigés par exemple dans les directions x et y. Ces champs sont par exemple créés par deux bobines 70 et 72, alimentées par des amplificateurs respectifs 74 et 76, à sortie réglable. Le dispositif comporte de plus un circuit 78, à micro-contrôleur, destiné à fournir les valeurs de réglage des deux champs composant le champ résultant Hp. Ce circuit de commande 78 peut également assurer le séquencement de la mesure, en réponse à un signal appliqué sur une entrée 80.

Un tel dispositif permet de lire l'information sur le nombre de tours quel que soit l'angle $\theta$ fait par le champ Ht de l'élément tournant 26. Pour cela, le circuit 78 est prévu pour superposer, lors de la lecture, un champ Hp au champ Ht et le faire varier progressivement jusqu'à ce que la résultante Ht + Hp corresponde à l'angle $\theta_A$ ou $\theta_B$. Au cours de ce déplacement d'entraînement des bulles, le champ Hp est commandé de façon que la résultante Hp + Ht reste approximativement d'amplitude constante. Ainsi, comme le montre la figure 9, on passe du point initial P au point final Q correspondant à l'angle $\theta_A$ par les positions successives R et S. Une fois arrivé au point Q, la procédure de lecture avec mise en vibration des bulles est la même que précédemment. Puis, dès la fin de la lecture, le champ Hp est ramené à zéro.

Une condition impérative est qu'on doit éviter d'annuler le champ plan total Ht + Hp au cours de l'activation ou de l'arrêt de Hp car cela risquerait de provoquer la disparition des bulles.

La variation progressive puis l'arrêt de Hp doivent être rapides comparés à la rotation de l'aimant tournant 26. Dans le cas, déjà envisagé, d'une vitesse maximale de 12000 t/m, on utilisera par exemple une durée d'activation de 50 microsecondes.

Ce procédé de lecture permet de connaître le nombre de tours effectués quelle que soit l'orientation de l'aimant, et en particulier lors de la mise en marche du dispositif.

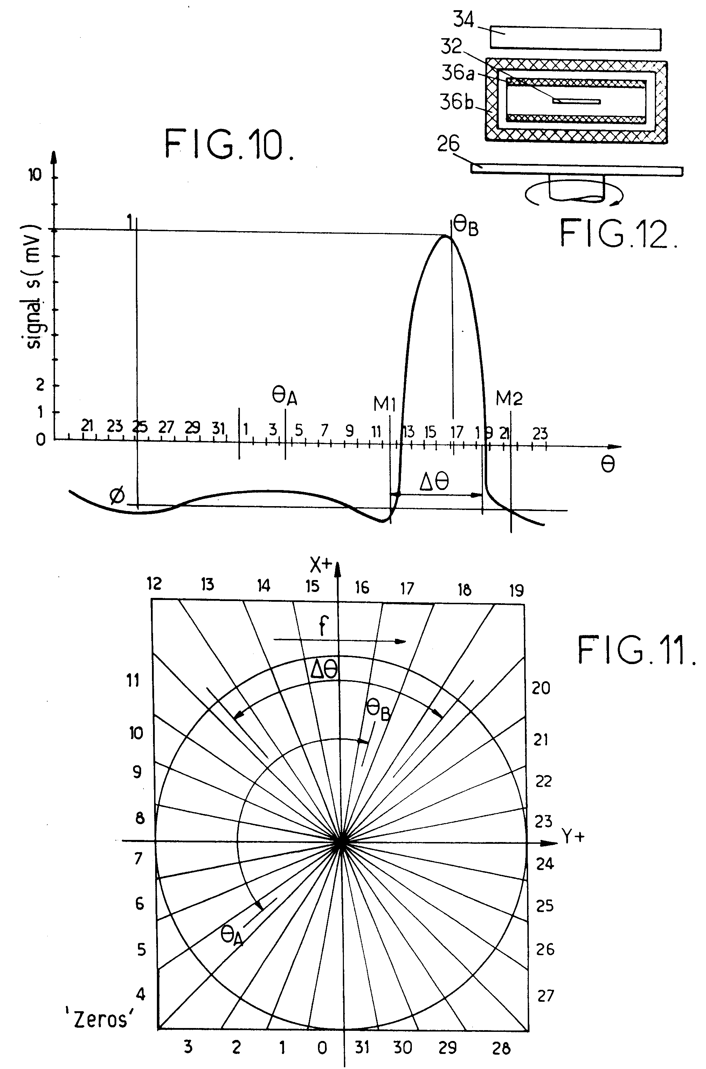

Les caractéristiques réelles du micro-circuit font que la courbe de variation du signal de sortie S en fonction de l'angle θ n'a pas la forme régulière montrée en figure 2 et se rapproche par exemple de la courbe montrée en figure 10, où les indices portés en abscisse correspondent aux orientations du champ dans les secteurs correspondants de la figure 11. Une oscillation d'un champ alternatif Ha de direction fixe oblige à rester dans une zone limitée, proche de celle indiquée par Δθ sur les figures 10 et 11. La figure 10 montre que, dans de nombreux cas, une oscillation du champ résultant limitée à cette zone ne permet pas d'obtenir de façon stable une même valeur extrême basse. Dans ce cas, le champ alternatif de direction constante, créé par une bobine unique 36 dans le cas de la figure 3, est remplacé par un champ tournant alternatif Ha, créé par exemple par composition du champ de deux bobines croisées 36a et 36b, comme le montre la figure 12. Un tel champ tournant permet de dépasser largement la zone dans laquelle le signal s varie notablement et d'obtenir un écart stable entre les valeurs maximale et minimale, qualifiées de 1 et Ø sur la figure 10. La lecture de zéro peut par exemple s'effectuer aux points M1 et M2 sur la figure 10, ou même, plus fréquemment, au delà.

La séquence de lecture peut être similaire à celle déjà décrite pour le premier mode de réalisation. Elle intervient lorsque l'angle θ prend la Θ'$_A$ Θ $_B$ ou choisie, entre le maximum et un des minima.

Dès réception de l'impulsion de lecture, les bobines d'excitation 36a et 36b sont alimentées pour fournir un champ tournant alternatif, d'amplitude suffisante pour arriver au zéro. La fréquence du champ tournant sera généralement d'environ 10 kHz étant donné la difficulté ou créer des courants véritablement sinusoïdaux dans les bobines 36a et 36b à fréquence très élevée. L'intensité constante du champ tournant pourra être du même ordre de grandeur que celle du champ de propagation.

L'alimentation des bobines sera généralement faite de façon que la lecture intervienne toujours dans le même sens, qui peut être celui indiqué par la flèche f sur la figure 1. A titre d'exemple, le champ tournant alternatif peut être prévu pour provoquer d'abord la lecture des zéros par venue dans la plage 4, puis la lecture des 1 par venue dans la plage 17 (figure 11).

Il est possible de multiplier le dispositif en pensant passer deux courants de natures différentes dans la même bobine.

Comme dans le cas précédent, il faut éviter d'annuler le champ total Ht + Hp. Ce résultat peut être atteint en commandant les courants de façon que la variation du champ puisse être représentée par un vecteur dont le pointe suit approximativement le carré circonscrit sur la figure 11.

Parmi les caractéristiques favorables de l'invention, du moins dans certains modes de réalisation, on peut relever les points suivants. La sécurité de fonctionnement et la fiabilité sont élevées. Si l'opération de lecture est interrompue par manque de courant, les bulles restent à leur place si bien que le nombre de tours reste sauvegardé. Si le codeur angulaire indique un angle erroné de sorte que l'opération de lecture se déclenche en-dehors de la phase de lecture ordinaire, les bulles n'en sont pas affectées.

Il est possible d'utiliser des séquences de bulles comportant des bulles successives (ce qui est le cas des cycles de Bruijn) puisque le détecteur passif peut être extérieur aux boucles. Le nombre de bits à lire par boucle est alors minimal : 5 bits pour 32 pas de longueur. L a consommation est réduite. Enfin, l'ensemble peut être réalisé sous forme d'un circuit intégré d'application spécifique ou ASIC.

## Revendications

1. Dispositif à micro-circuit portant au moins une boucle (14) à motifs de circulation de bulles magnétiques, des moyens (42) de génération de bulles sur un motif, des moyens de création d'un champ de polarisation (Hb) orthogonal au micro-circuit, des moyens de création d'un champ tournant d'entraînement (Ht) des bulles et des moyens de lecture destinés à détecter la présence d'une bulle sur au moins un motif particulier, caractérisé en ce que lesdits moyens de lecture comprennent des moyens de création d'un champ alternatif (Ha) dans le même plan que le champ tournant d'entraînement, permettant de faire osciller le long d'un motif une bulle éventuellement présente sur ce motif.

2. Dispositif à micro-circuit de comptage du nombre de tours du champ d'un aimant rotatif (26), ayant au moins une boucle (14) comportant plusieurs motifs de circulation de bulles magnétiques, placées par rapport à l'aimant de façon que chaque tour du champ tournant fasse passer les bulles d'un motif de chaque boucle au motif suivant, des moyens de création d'un champ de polarisation (Hb) orthogonal au micro-circuit et des moyens de lecture de la présence d'une bulle magnétique sur un motif particulier de la boucle ou de chaque boucle, caractérisé en ce que les moyens de lecture comprennent des moyens de détection de l'orientation du champ tournant, et des moyens de création d'un champ magnétique alternatif (Ha) à fréquence supérieure à la fréquence angulaire maximale du champ tournant de l'aimant lorsque ledit champ tournant est dans une orientation déterminée, et des moyens de détection de l'oscillation de la bulle éventuellement présente sur au moins un motif par variation d'un signal de sortie à la fréquence du champ alternatif.

3. Dispositif suivant la revendication 1 ou 2, caractérisé en ce que le rapport entre les deux fréquences dépasse 50.

4. Dispositif suivant la revendication 1, 2 ou 3, caractérisé en ce que le champ alternatif est d'orientation fixe et a une amplitude du champ à peu près moitié de la valeur du champ tournant.

5. Dispositif suivant l'une quelconque des revendications 1 à 4, caractérisé en ce que lesdits moyens de création d'un champ alternatif sont commandés pour une orientation du champ tournant telle que la position qu'il donne à la bulle provoque un signal de sortie sensiblement égal à la moitié du signal maximum.

6. Dispositif selon la revendication 1, 2 ou 3, caractérisé en ce que le champ alternatif est tournant.

7. Dispositif selon la revendication 6, caractérisé en ce que le dit champ tournant est créé par deux bobines croisées (36a, 36b).

8. Dispositif suivant l'une quelconque des revendications 1 à 7, caractérisé en ce que la boucle ou chaque boucle contient une séquence de bulles constituant un cycle de Bruijn et en ce que les moyens détecteurs associés à la boucle sont en nombre juste suffisant pour déterminer simultanément la position de l'ensemble de la séquence dans la boucle.

9. Dispositif suivant la revendication 8, caractérisé en ce que lesdits moyens détecteurs comportent :
   - plusieurs détecteurs magnéto-résistifs actifs (20a) associés à des motifs successifs de la boucle,
   - un détecteur passif (20b),
   - un amplificateur différentiel (48), dont une entrée est attaquée par les détecteurs actifs par l'intermédiaire d'un multiplexeur (50) et dont l'autre entrée est attaquée par le détecteur passif,
   - et un comparateur à seuil (52).

10. Dispositif selon la revendication 8 ou 9, de comptage du nombre de tours du champ tournant, caractérisé en ce que les moyens de détection de l'orientation comprennent un codeur angulaire numérique (30) et des moyens de décodage, de fourniture d'un signal de passage à l'orientation de mesure et de fourniture d'un signal différencient l'augmentation et la diminution d'un tour.

11. Dispositif selon l'une quelconque des revendications précédentes, caractérisé en ce qu'il comprend, de plus, des moyens (70,72) de création d'un champ orientable dans le plan du microcircuit et d'amenée progressive du champ tournant d'entraînement et dudit champ dans le plan du microcircuit jusqu'à une orientation de mesure.

12. Dispositif selon la revendication 11, caractérisé en ce que les moyens de création du champ supplémentaire orientables dans le plan du microcircuit sont prévus de façon à maintenir la résultante du champ tournant et du champ supplémentaire orientable à une valeur sensiblement constante.

FIG.1.

FIG.2.

FIG.3.

# FIG.4.

# FIG.5.

# FIG.6.

# FIG.7.

FIG.8

FIG.9.

FIG.10.

FIG.12.

FIG.11.

'Zeros'

Office européen
des brevets

# RAPPORT DE RECHERCHE EUROPEENNE

Numero de la demande

EP 95 40 0245

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | IBM TECHNICAL DISCLOSURE BULLETIN., vol. 16, no. 6, Novembre 1973 NEW YORK US, pages 1809-1810, ARGYLE ETAL 'DYNAMIC DETECTION OF INFORMATION IN MAGNETIC BUBBLE DOMAIN WALLS.' * page 1810, ligne 14 - page 1810, ligne 26; figure 2 * | 1 | G11C19/08 G01D5/14 |
| A | PATENT ABSTRACTS OF JAPAN vol. 15 no. 247 (P-1219) ,25 Juin 1991 & JP-A-03 078619 (FANUC LTD) * abrégé * | 1,2 | |
| A | PATENT ABSTRACTS OF JAPAN vol. 17 no. 175 (P-1516) ,5 Avril 1993 & JP-A-04 331317 (KUDO YOSHIAKI) * abrégé * | 1,2 | |
| A | US-A-3 820 092 (BOBECK) * le document en entier * | 1 | |
| A | US-A-3 883 858 (LIENHARD ET AL) * le document en entier * | 1 | DOMAINES TECHNIQUES RECHERCHES (Int.Cl.6) G11C G01D |
| D,A | FR-A-2 686 993 (SAGEM-FRANCE) * le document en entier * | 1,2 | |

Le présent rapport a été établi pour toutes les revendications

| Lieu de la recherche | Date d'achèvement de la recherche | Examinateur |
|---|---|---|
| LA HAYE | 28 Juin 1995 | Degraeve, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)